# EUROPEAN PATENT APPLICATION

(11) **EP 4 715 464 A2**
(43) Date of publication of application: **25.03.2026**
(21) Application number: 25195596.9
(22) Date of filing: 13.08.2025
(51) Int. Cl.: G03F 1/36

(54) **SYSTEMS AND METHODS FOR MULTI-LAYER OPTICAL PROXIMITY CORRECTION METROLOGY USING ELECTRICAL TEST DATA**

(30) Priority: 18.09.2024 US 202418888453
(71) Applicant: INTEL Corporation, Santa Clara, CA 95054 (US)
(72) Inventor: THULASI, Sunita, Portland OR, 97229 (US); MORTON, Seth, Beaverton, OR, 97006 (US); LEE, Cheng-Tsung, Beaverton, OR, 97006 (US); SIDDHAMSHETTY, Prashanth Kumar, Portland, OR, 97239 (US); JONAYAT, A S M, North Plain, OR, 97133 (US)
(74) Representative: HGF

(57) **Abstract**

Systems and methods for multi-layer optical proximity correction (OPC) metrology. The OPC metrology system accesses three layers of OPC contour data, the layers of OPC data generated for a drawn integrated circuit layout characterized for a foundry process node. The three layers include a first metal layer, a second metal layer, and a via layer. A feature, such as a via, is formed in the three layers. The system receives user input defining a check (geometric analysis) for the feature, and a limit. The system performs the check on the features and generates a flag for the feature when the limit is exceeded. The system can generate output that reflects the integration of multiple checks and predicts risks and yields for the foundry process node.

## Description

### BACKGROUND

Optical proximity correction (OPC) is an example of a resolution enhancement technique (RET) used to improve yields. OPC methods involve modifications to drawn layers. The evaluation of the effectiveness of the OPC is referred to as OPC metrology. As feature sizes shrink and design ease of use ideas such as flexible pitch design rules become more common, improvements to OPC metrology are desirable.

### BRIEF DESCRIPTION OF THE DRAWINGS

FIG. 1A illustrates drawn via coverage and an optical proximity correction (OPC) modified via associated with a first metal layer and a second metal layer, in accordance with various embodiments.
FIG. 1B depicts a shift in the first metal layer and a shift in the second metal layer from OPC and illustrates the resulting via coverage.
FIG. 1C illustrates a method to estimate via-to-metal shorting based on an OPC modified via and drawn metal without the benefit of the provided methodology.
FIG. 1D depicts the estimate of FIG. 1C improved by the methodology disclosed herein.
FIG. 2A is a simplified illustration of an unshifted design.
FIG. 2B is a simplified illustration of the design of FIG. 2A after a registration shift.
FIG. 3 provides an enlarged view of a via from FIG. 2B, to illustrate the OPC contours of the shifted design.
FIG. 4 is a block diagram depicting an example environment in which embodiments may operate.
FIG. 5 is an exemplary architectural block diagram of one or more application modules that may be operating in the system for OPC metrology using electrical test data, in accordance with various embodiments.
FIG. 6 illustrates process steps of a method for OPC metrology using electrical test data, in accordance with various embodiments.
FIG. 7 illustrates a multi-processor environment in which embodiments may be implemented.
FIG. 8 is a block diagram of an example processor unit to execute computer-executable instructions as part of implementing technologies described herein.

### DETAILED DESCRIPTION

Optical proximity correction (OPC) is a methodology that adjusts the design of a mask layout (i.e., mask layers) corresponding to an integrated circuit so that features formed during fabrication in an integrated circuit structure based on the mask layout more closely match desired features. Whereas previously assumptions were that locations of fabricated features were fairly close to their drawn locations, using flexible pitch design rules has introduced an additional amount of movement in layers from drawn to the final fabricated product. The evaluation of the OPC methodology as compared to the resulting fabricated product and yield presents a difficult technical challenge.

To evaluate the OPC methodology, algorithmic OPC metrology is generally performed on OPC simulated contours at a full chip level. Since masks are manufactured for each layer in the chip, OPC simulations and hence OPC metrology are performed for each mask. During OPC metrology, the drawn layout for adjacent layers may be used. For example, drawn metal layout may be used during via post-OPC checks.

With some available solutions, OPC is performed on a per-layer basis (i.e., one layer evaluated at a time, without considering other layers). Hence the associated OPC metrology is also single-layer, on a per-layer basis, with some assumptions based on the drawn locations of polygons for adjacent layers.

Another available fabrication metrology approach uses a top-down SEM (scanning electron microscopy) image to characterize edge placement combined with single-layer OPC metrology to optimize a mask solution. However, this metrology approach is particularly challenging for multi-layer stacks; for example, it would be unreliable to determine via-to-metal shorting below a shorting margin with a 2D (two-dimensional) SEM (scanning electron microscopy) image. High accuracy characterization is feasible using an inefficient cross-section TEM (transmission electron microscopy) image but may result in significant cycle time plus engineering cost.

With continued emphasis on design ease-of-use and with the introduction of flexible pitch design rules on metal layers, the per-layer assumptions based on drawn locations of polygons of adjacent layers have become less accurate because significant sizing and shifting of metal lines can happen during OPC. The significant sizing and shifting of metal lines from the OPC operation can introduce further technical challenges, such as vulnerability to defects like via opens and via-to-metal shorts. To improve upon the available OPC metrology and make the OPC metrology relevant and meaningful in these scenarios, it is desirable to be able to map/link the tolerances of OPC metrology predictions of risk modes such as via coverage and via-to-metal shorts (also referred to as shorting) to electrical test data from the fabricated products (also referred to as E-test data, and "data from the fab"), in which via opens and via-to-metal shorts in manufactured product have been detected.

Additionally, with advanced tech nodes, feature sizes get smaller and the tolerance for mis-registration (misalignment) between individual metal and via layers during fabrication, manufacturing, or processing operations gets smaller as well. It is important to have improved multi-layer metrology that can help highlight configurations at highest yield risk if masks are mis-registered and this can be fed back to design to achieve process friendly design layout as well.

Embodiments provide a technical solution to these technical problems and other related enhancements, in the form of systems and methods for multi-layer OPC metrology using electrical test data. Embodiments introduce a multi-layer OPC metrology method (module) that performs OPC simulations using 3 mask layers. Embodiments deliver an improved ability to predict risks, such as those of via opens and via-to-metal shorts. The multi-layer OPC metrology method is an improvement over existing per-layer OPC metrology methods (modules) because it better reflects the sizing and shifting of metal lines that can happen during OPC. Embodiments additionally link the tolerances of the OPC metrology predictions of risk modes (e.g., via coverage and via-to-metal shorts) to electrical test data from fabricated product. Additionally, embodiments use the E-test data characterization to determine optimal edge placement of and offer quick turnaround/delivery of new mask solutions.

This multi-layer OPC metrology method and the associated E-test based method of setting tolerances for predictions of risk modes is an enhanced method that assesses integrated risks (i.e., integrated layers) over previous solutions; moreover, this multi-layer OPC metrology methodology has been demonstrated to validate the OPC methodology used with full chip databases and products.

For the sake of brevity, conventional techniques related to signal processing, data transmission, signaling, control, machine learning models, radar, lidar, image analysis, and other functional aspects of the systems (and the individual operating components of the systems) may not be described in detail herein. Furthermore, the connecting lines shown in the various figures contained herein are intended to represent example functional relationships and/or physical couplings between the various elements. It should be noted that many alternative or additional functional relationships or physical connections may be present in an embodiment of the present disclosure.

Example embodiments are hereinafter described in conjunction with the following drawing figures, wherein like numerals denote like elements. Figures are not necessarily to scale. For the sake of brevity, well-known modules, structures, and devices may be shown in block diagram form to facilitate a description thereof.

Embodiments of multi-layer OPC metrology including electrical test data may be implemented in a variety of systems, apparatus, consumer products, such as electronic design automation (EDA) tools, computer aided design (CAD) tools, computing devices, and the like. Additionally, embodiments of systems that include multi-layer OPC metrology including electrical test data can be found in machine-readable storage media having machine-readable instructions that when executed cause one or more processor to perform a method as described herein.

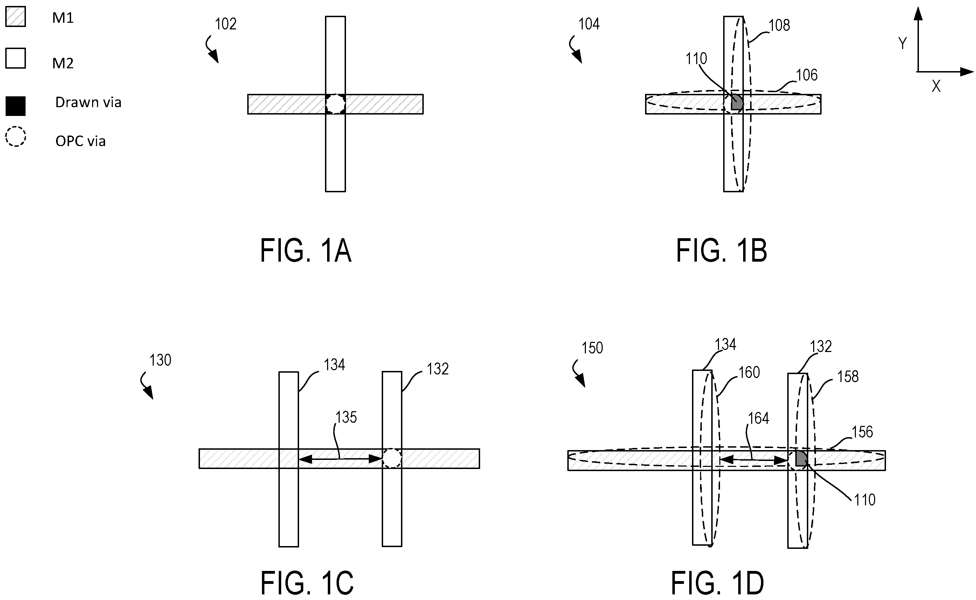

FIG. 1A view 102 illustrates drawn via coverage and an optical proximity correction (OPC) for the via between a first metal layer and a second metal layer, in accordance with various embodiments. FIGS. 1A-1D show a first metal layer (arbitrarily assigned M1) drawn horizontally with diagonal lines in it, and a second metal layer (arbitrarily assigned M2) is drawn vertically without fill. A square shaped overlap, shaded black, represents a drawn via between M1 and M2. After OPC on the drawn via, a modified via results, depicted round and white with a dashed outline. In some existing solutions, OPC metrology calculates the via coverage based on the depicted modified via in FIG. 1A. As is illustrated in the following figures, the assumptions based on drawn locations of polygons may no longer be accurate as significant sizing and shifting of metal lines can happen during OPC.

FIG. 1B and FIG. 1D depict an OPC shift 106/156 in the first metal layer (illustrated with dashed outline) and an OPC shift 108/158 in the second metal layer and predicts the resulting via coverage 110. While the drawings are not to scale, it is intentional that the post-OPC via coverage 110 in image 104 is shown as a smaller area than the area comprising the OPC modified via in FIG. 1A. In the provided embodiments, the multi-layer OPC metrology advantageously calculates via coverage based on the shift 106/156 and the shift 108/158 (experienced by the metal above (M1) and the metal below (M2) the via), thereby more accurately predicting the via coverage 110. The calculation performed may include a geometric analysis. In practice, a user can define a via open as, for example, the calculated area being below a limit that is a minimum area for via coverage 110, and embodiments can set a flag upon determining an open, and/or keep count of such instances/ and/or generate a location map where the user defined opens occur.

FIG. 1C image 130 illustrates an OPC metrology method to estimate/predict via-to-metal shorting using drawn layers. In the example, the first trace 132 of the M2 and the second trace 134 of the M2 are depicted as being nearest neighbors (i.e., no traces in between them) and substantially parallel to one another (wherein substantially means plus or minus 5 degrees). The OPC metrology method performs a geometric analysis to estimate/predict via-to-metal shorting based on the distance 135 between the peripheral edge of the OPC modified via at first trace 132 (the modified vias are also referred to as "via contours") and the nearest drawn edge of the second trace 134. It is notable that the distance 135 does not accommodate the shift in the second trace 134, which means that estimates of via-to-metal shorting calculated this way are less accurate.

FIG. 1D image 150 illustrates improved predictions of via-to-metal shorting by embodiments of the multi-layer OPC metrology method. The provided embodiments have some features from FIG. 1C and improve upon it with Multi-layer OPC metrology checks that use the OPC contours of two metal layers to detect via opens and via-to-metal shorts. Image 150 includes the OPC shift 106/156 in the first metal layer (illustrated with dashed outline) and the OPC shift 108/158/160 in the second metal layer. In provided embodiments, the multi-layer OPC metrology estimates/predicts via-to-metal shorting based on the distance 164 between the peripheral edge of the OPC contour via and the nearest edge of the OPC contour of the second trace 160 (shifted second trace 160). While the images are not to scale, it is intentional that distance 164 is smaller than distance 135. Accordingly, provided embodiments more accurately model the shifted metal lines and generate more accurate predictions of via-to-metal shorts than previous methods.

Additionally, the provided embodiments include the ability to create checks that include limits or tolerances to more closely tie the estimates/predictions to measured data obtained from fabricated products. To determine appropriate limits, embodiments utilize electrical test data. Embodiments use electrical test (E-test) data obtained from systematic skews. For example, electrical test data for via opens is obtained from skews designed specifically to evaluate via opens and can be the source of a limit/tolerance for a via area below which the via is open. Similarly, embodiments can include electrical test data from via skews designed to evaluate via-to-metal shorting. The via-to-metal shorting check in the multi-layer OPC metrology module can be run on the same skew layout on the test chip, and hence, a direct mapping between the via-to-metal shorting distance predicted by the OPC contours and electrical data can be obtained. Similarly, limits/tolerances can be obtained for via coverage area using the skew layout on the test chip.

When the provided embodiments are executed on a design database, the definition of a check and its respective limits can be pre-defined by the user, and checks (checks may be geometric analysis of a feature) can be created to flag a location in the database to be evaluated. The limits can be upper thresholds or lower thresholds, areas, ranges, or any combination thereof. For example, for a user defined via coverage estimate/prediction/check, the user can select a limit from the E data that is an area, and the multi-layer OPC metrology module can use create a via coverage check that performs a geometric analysis to predict an area of overlap between the feature (the via) and the respective OPC contours for M1 and/or M2 traces; when the geometric analysis determines that the predicted area is less than the limit, this means that the predicted area of overlap of the via and the respective metal OPC contour exceeds the limit or is below/smaller than the limit. The multi-layer OPC metrology module can, as output results, set a flag, mark the location, and/or keep a count of such flags.

Likewise, embodiments can receive user defined checks and limits for estimates/predictions of via-to-metal shorting. In this scenario, the limit can be a distance between the OPC contour of the features include the OPC contour of the via and the OPC contour of the metals, and when the check/geometric analysis predicts a distance that exceeds (i.e., is below or smaller than) the limit, this means that there is a risk of via to metal shorting. When the user defined limit for the via-to-metal shorting check is exceeded, the multi-layer OPC metrology module can, as output results, set a flag, mark the location, and/or keep a count of such flags.

In various embodiments, the multi-layer OPC metrology module can be a means for predicting multi-layer risks and yields for a process node at a manufacturing/processing foundry or facility.

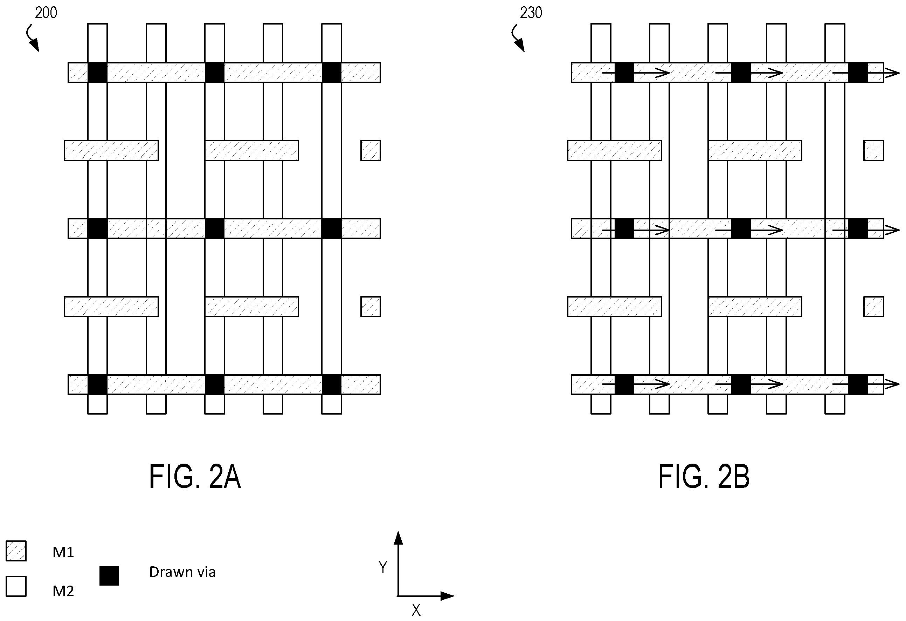

FIG. 2A illustrates an unshifted design. FIG. 2B illustrates a skew design for an electronic test, depicting the design of FIG. 2A after a via-to-metal registration skew. The registration skew may also be referred to as a misalignment. The image 200 and the image 230 are plan views (e.g., X-Y). As with the earlier figures, traces of a first metal layer (M1) are depicted horizontally with diagonal lines, and traces of a second metal layer (M2) are depicted vertically unshaded. Drawn vias are depicted as squares shaded black. Arrows in image 230 show the shift or movement of vias to the right on the page. In a non-limiting example, image 230 depicts a 22 nanometer (22 nm) registration shift in the design. Note that the vias are spatially away from the drawn overlap of M1 and M2 in FIG. 2B (i.e.., there is a gap).

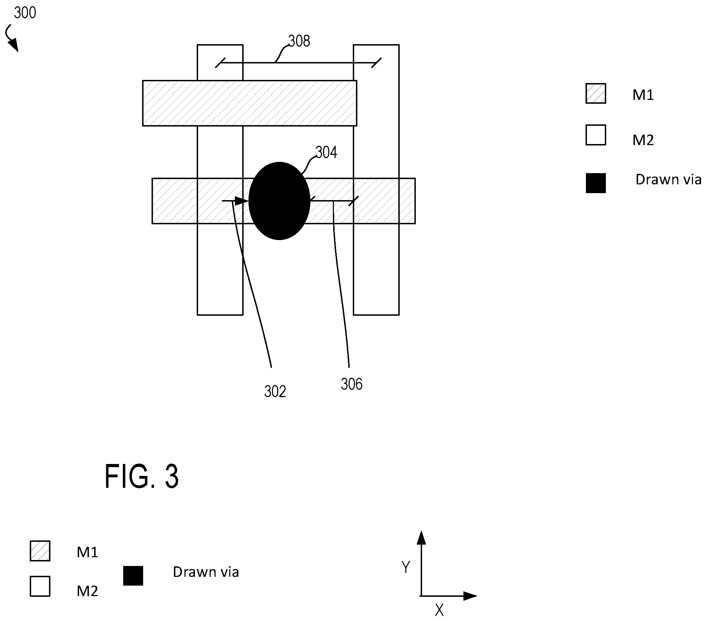

FIG. 3 is an enlarged view of the OPC via contours of the shifted design of FIG. 2B. Image 300 shows how the provided multi-layer OPC metrology module can predict OPC edge placement. A first M2 trace and a second M2 trace are shown separated by a pitch 308; the pitch 308 being a measurement from metal centerline to next neighbor metal centerline. The OPC contour of the via 304 has shifted the distance 302 from the leftmost M2 trace, toward the rightmost M2 trace (the distance 302 is analogous to the distance depicted by the arrows in FIG. 2B), and the left edge of the next (neighbor) or rightmost M2 metal trace is distance 306 away. While via 304 is drawn to be, and intended to be, associated with the leftmost M2 metal trace, it poses a risk of an open at its intended location, as well as a short at its unintended, shifted destination.

Embodiments create three layer, integrated, checks, as follows. User input is received that defines, for the three layers, which checks are to be created, such as, opens, shorts, via coverage, via-to-metal shorts, or other geometric analysis, for the interaction of the three layers. The user input received for individual checks includes a user defined (i.e., predetermined) limit, wherein "limit" is used broadly to include a range, threshold, area, etc., as appropriate for the check, and may include a corresponding tolerance. The user input is based on a review of E data from test wafers fabricated in the manufacturing and fabrication facility and using the process node under study. The user inputs are sometimes referred to as predetermined limits because they are set prior to performing the multi-layer OPC metrology checks described herein.

Embodiments perform the checks based on the user inputs. In an example check for via-to-metal short, the predetermined limit can be a minimum allowable distance. The embodiments compare distance 306 to the predetermined limit or minimum allowable distance. When distance 306 exceeds (is smaller than) the predetermined limit, the potential via-to-metal short on the rightmost metal 2 trace may be flagged as likely, counted, and/or its location may be logged for future review.

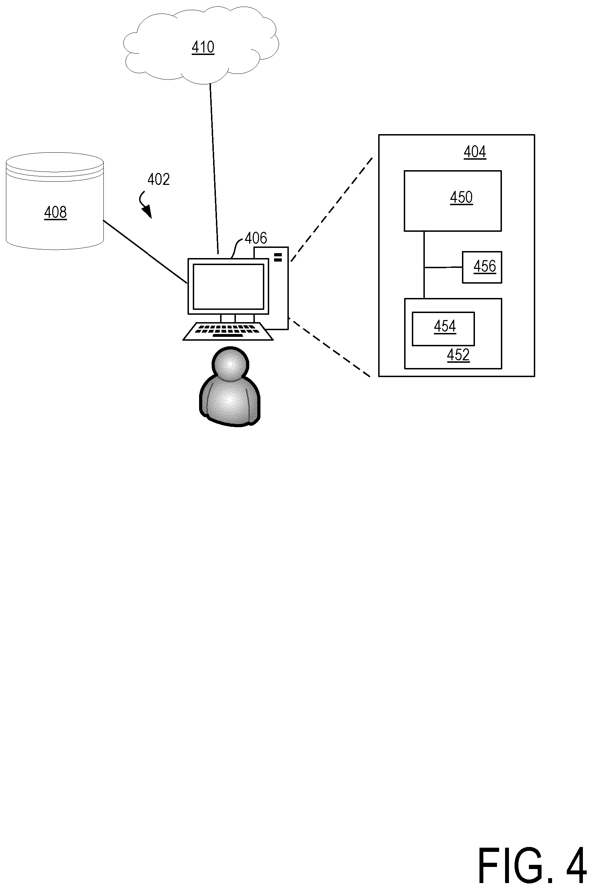

FIG. 4 illustrates an exemplary environment 400 in which embodiments may operate. The OPC system with multi-layer OPC metrology using electrical test data (shortened herein to system 402) may operate on a compute device 406 and be in wire or wireless communication with one or more database(s) 408, and in wireless communication with the cloud 410. The system 402 includes a multi-layer OPC metrology module 404. The system 402 may be an OPC system running on an external platform or be an in-house OPC system.

As used herein, the term "module" may refer to any hardware, software, firmware, electronic control component, processing logic, and/or processor device, individually or in any combination. In various embodiments, a module is one or more of: an application specific integrated circuit (ASIC), a field-programmable gate-array (FPGA), an electronic circuit, a computer system comprising a processor (shared, dedicated, or group) and memory that executes one or more software or firmware programs, a combinational logic circuit, and/or other suitable components that provide the functionality attributed to the module. In various embodiments, a software program in a module encodes an algorithm or procedure of rules for the processor to execute. In various embodiments, all or part of the functionality of the control module can be performed by a machine learning model (ML), neural net (NN) or other variation of artificial intelligence.

As used herein, a "computing system" or "compute device" refers to any of a variety of computing devices and includes systems comprising multiple discrete physical components. In some embodiments, the computing systems are located in laptop computer, a desktop computer, a data center, such as an enterprise data center (e.g., a data center owned and operated by a company and typically located on company premises), managed services data center (e.g., a data center managed by a third party on behalf of a company), a collocated data center (e.g., a data center in which data center infrastructure is provided by the data center host and a company provides and manages their own data center components (servers, etc.)), cloud data center (e.g., a data center operated by a cloud services provider that host companies applications and data), and an edge data center (e.g., a data center, typically having a smaller footprint than other data center types, located close to the geographic area that it serves).

As used herein, the terms "processor unit", "processing unit" or "processor" may refer to any device or portion of a device that processes electronic data from registers and/or memory to transform that electronic data into other electronic data that may be stored in registers and/or memory. A processor unit may be a system-on-a-chip (SOC), and/or include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

In FIG. 4, the multi-layer OPC metrology module 404 is embodied as a control circuit. In various embodiments, the control circuit is realized as an enhanced computer system, comprising a computer readable storage device or media, memory 452, for storage of instructions, algorithms, and/or programs, such as vehicle-target localization algorithm and a plurality of preprogrammed thresholds and parameters, the processor 450 to execute the program 454, and input/output interface (I/O) 456. The computer readable storage device or media, memory 452, may include volatile and nonvolatile storage in read-only memory (ROM), random-access memory (RAM), and keep-alive memory (KAM), for example. KAM is a persistent or non-volatile memory that may be used to store various operating variables while the processor 450 is powered down. The memory 452 may be implemented using any of a number of known memory devices such as PROMs (programmable read-only memory), EPROMs (electrically PROM), EEPROMs (electrically erasable PROM), flash memory, or any other electric, magnetic, optical, or combination memory devices capable of storing data, some of which represent executable instructions, used by the processor 450 in controlling the system 402. In various embodiments, processor 450 is configured to implement the system 402. The memory 452 may also be utilized by the processor 450 to cache data, to temporarily store results of comparisons and analyses, and the like. Information in the memory 452 may be organized and/or imported from an external source during an initialization or installment operation in a method; it may also be programmed via a user I/O interface.

The input/output interface (I/O) 456 may be operationally coupled to the processor 450 via a bus and enables intra-control circuit communication as well as extra-control circuit communication. The input/output interface (I/O) 456 may include one or more wired and/or wireless network interfaces and can be implemented using any suitable method and apparatus. In various embodiments, the input/output interface (I/O) 456 includes the hardware and software to support one or more communication protocols for wireless communication between the processor 450 and external sources, such as satellites, the cloud, communication towers and ground stations. In various embodiments, the input/output interface (I/O) 456 supports communication with technicians, and/or one or more storage interfaces for direct connection to storage apparatuses.

During operation of the system 402, the processor 450 loads and executes one or more algorithms, instructions, and rules embodied as program 454, and, as such, controls the general operation of the system 402. During operation of the system 402, the processor 450 may receive data from external sources (such as WiFi signal(s), the cloud 410, or other systems configured to operate within the computing device 406). In various embodiments of the system 402, the multi-layer OPC metrology module 404 may: perform operations attributed to the system 402 in accordance with an algorithm; perform operations in accordance with state machine logic; and perform operations in accordance with logic in a programmable logic array.

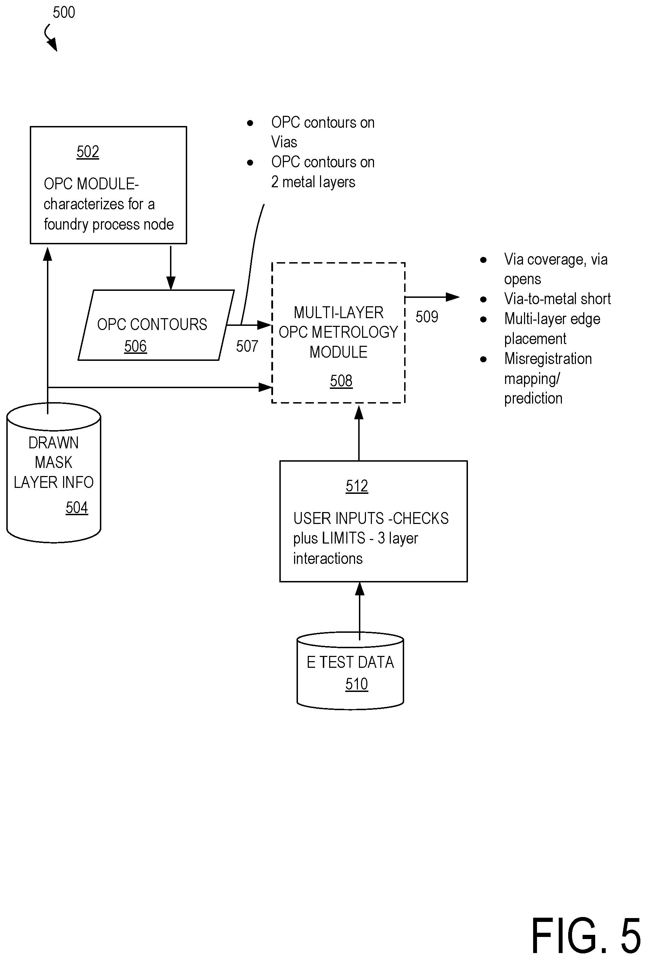

While the exemplary embodiment of the system 402 is described in the context of the multi-layer OPC metrology module 404 implemented as a fully functioning enhanced computer system, those skilled in the art will recognize that the mechanisms of the present disclosure are capable of being distributed as a program product including program 454 and predefined parameters. Such a program product may comprise an arrangement of instructions organized as multiple interdependent program code modules (see, e.g., FIG. 5, 500), each configured to achieve a separate process and/or perform a separate algorithmic operation, arranged to manage data flow through the system 402. The program code modules may each comprise an ordered listing of executable instructions for implementing logical functions for the processes performed by the system 402. The instructions in the program code modules, when executed by a processor (e.g., processor 450), cause the processor to receive and process signals, and perform logic, calculations, methods and/or algorithms as described herein for automatically and in real-time performing vehicle-target localization and generating associated commands.

Once developed, the program code modules constituting a program product may be stored and distributed individually, or together, using one or more types of non-transitory computer-readable signal bearing media may be used to store and distribute the instructions, such as a non-transitory computer readable medium. Such a program product may take a variety of forms, and the present disclosure applies equally regardless of the type of computer-readable signal bearing media used to carry out the distribution. Examples of signal bearing media include recordable media such as floppy disks, hard drives, memory cards and optical disks, and transmission media such as digital and analog communication links. It will be appreciated that cloud-based storage and/or other techniques may also be utilized as memory and as program product time-based viewing of clearance requests in certain embodiments.

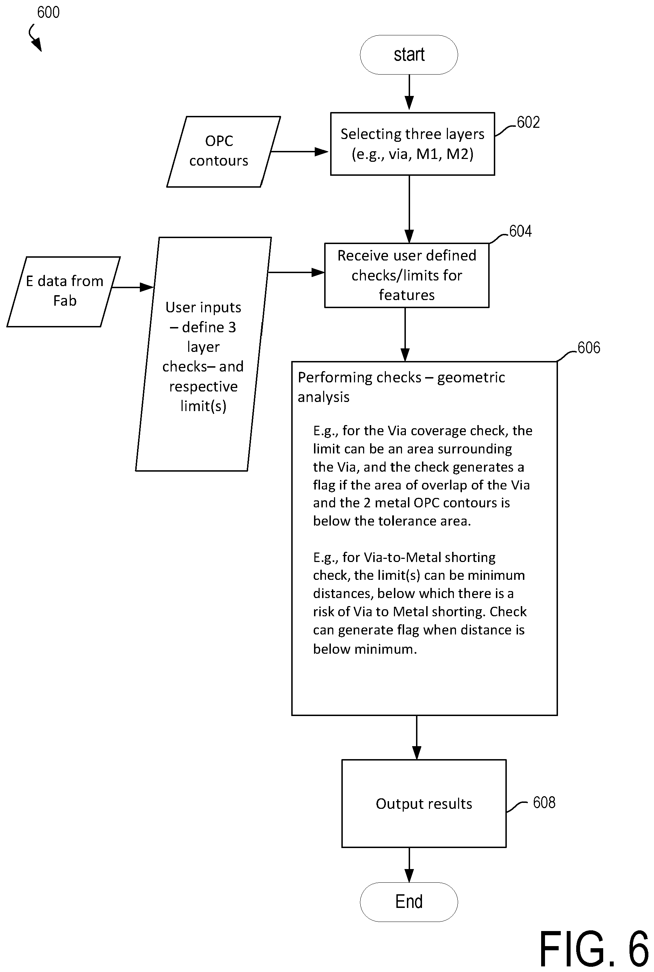

FIG. 5 is an exemplary embodiment 500 of the system 402 showing an architectural block diagram of one or more application modules (e.g., the aforementioned interdependent program code modules) that may be operating in the system 402. The modules in FIG. 5 are referenced in conjunction with FIG. 6, which illustrates operations of a method 600 for Multi-layer OPC metrology using electrical test data. It is to be understood that FIG. 5 illustrates one example of a set of modules that can be included in the system 402. In other embodiments, the system 402 can have more or fewer modules than those shown in FIG. 5. Further, separate modules can be combined into a single module, and a single module can be split into multiple modules.

As depicted in embodiment 500, the OPC module 502 in the system 402 receives or accesses the drawn mask layer information, generally from a database 504. The OPC module 502 performs optical proximity correction (OPC) on the drawn layers, generating output data called OPC contours 506. At 602, the provided multi-layer OPC metrology module 508 accesses three layers 507 from the OPC contours 506 data. As indicated in FIG. 5, the three layers of optical proximity correction (OPC) data are three of a plurality of layers of OPC contour data generated for a drawn integrated circuit layout characterized for a foundry process node. As described herein, the three layers may be two metal layers and the via layer between/connecting the two metal layers.

At 604, the multi-layer OPC metrology module 508 receives user inputs 512 generated from E test data 510, specifying desired checks associated with the three layers and specifying relevant limits, as described herein. At 606, the OPC metrology module 508 performs the userspecified check(s) to estimate or predict potential issues for the three selected layers. For simplicity, the checks have been described herein as if they are performed one at time, but in practice, the user may define multiple checks and their respective limits at once, and the multi-layer OPC metrology module 508 can perform the multiple checks concurrently.

As described herein, the multi-layer OPC metrology module 508 performs the checks or geometric analysis per the user input, and generates output results, such as a flag when the limit is exceeded, wherein exceeded is relative to the check itself. For example, for the via coverage check, the user input limit can be a minimum area surrounding the via, and the check generates a flag if the area of overlap of the via and the OPC contours of the respective M1/M2 exceeds/is less than the limit minimum area. In another example, for a via-to-metal shorting check, the user input limit can be a minimum distance, below which there is a risk of via-to-metal shorting. The check can generate a flag when the calculated distance is below the limit/minimum. In another example, multi-layer edge placement checks can be performed, in which the post-OPC shifting of the layers that results from the fabrication process (e.g., as caused by sidewall tapering in the process) can be considered and integrated risks can be flagged; For example, this check can generate a flag when the post-OPC shifting exceeds (is larger than) a limit distance and poses a risk for via-metal shorts. In some embodiments, the user inputs include entering a metal pitch (e.g., 20 nanometers to 1 micron) and then entering a range; for example, a via open is check fail defined as a shift away from the metal centerline of more than 30% of the pitch (i.e., exceeds 30%). As may be appreciated, other checks and limits may be employed for the interactions between the three layers. In various embodiments, the output may further be consolidated into a predicted yield or predicted risk of a type of failure for drawn layouts or specific integrated circuits at the foundry process node.

At 608, the Multi-layer OPC metrology module 508 outputs the results 509 of the checks. The output/results of the check or checks can be as simple as one or more flags related to a check, be integrated into a prediction of a risk related to the check, and/or be integrated into a predicted yield at the process node in the fabrication/manufacturing facility for the integrated circuit layout. Non-limiting examples of output that the multi-layer OPC metrology module 508 can generate include a tabulated count of via coverage issues (i.e., occurrences of flags), a map of locations with via issues, a count and location for via opens; a via-to-metal short count and a map of via-to-metal short locations; predicted locations of multi-layer edge placement risk; and mis-registration risk assessment. After 608, the method 600 may end or be repeated.

Thus, systems and methods for multi-layer OPC metrology using electrical test data have been provided. Embodiments simulate and create checks using three layers and electrical test data from product fabricated at the intended manufacturing/fabrication facility and process node. The following description illustrates various context for usage and application of provided aspects of the present disclosure.

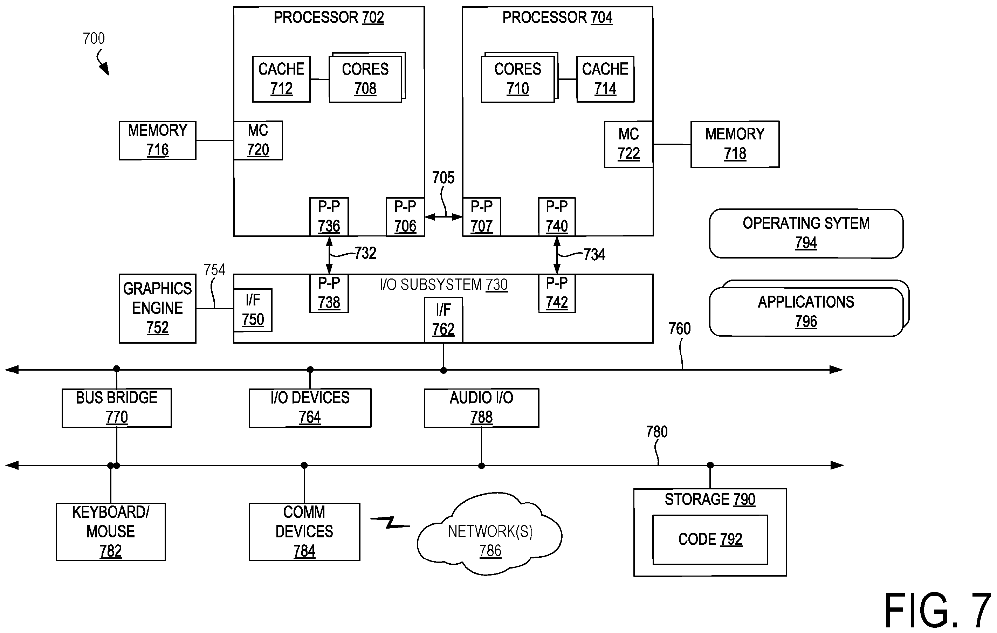

FIG. 7 illustrates a multi-processor environment in which embodiments may be implemented. Processor units 702 and 704 further comprise cache memories 712 and 714, respectively. The cache memories 712 and 714 can store data (e.g., instructions) utilized by one or more components of the processor units 702 and 704, such as the processor cores 708 and 710. The cache memories 712 and 714 can be part of a memory hierarchy for the computing system 700. For example, the cache memories 712 can locally store data that is also stored in a memory 716 to allow for faster access to the data by the processor unit 702. In some embodiments, the cache memories 712 and 714 can comprise multiple cache levels, such as level 1 (L1), level 2 (L2), level 3 (L3), level 4 (L4) and/or other caches or cache levels. In some embodiments, one or more levels of cache memory (e.g., L2, L3, L4) can be shared among multiple cores in a processor unit or among multiple processor units in an integrated circuit component. In some embodiments, the last level of cache memory on an integrated circuit component can be referred to as a last level cache (LLC). One or more of the higher levels of cache levels (the smaller and faster caches) in the memory hierarchy can be located on the same integrated circuit die as a processor core and one or more of the lower cache levels (the larger and slower caches) can be located on an integrated circuit dies that are physically separate from the processor core integrated circuit dies.

Although the computing system 700 is shown with two processor units, the computing system 700 can comprise any number of processor units. Further, a processor unit can comprise any number of processor cores. A processor unit can take various forms such as a central processing unit (CPU), a graphics processing unit (GPU), general-purpose GPU (GPGPU), accelerated processing unit (APU), field-programmable gate array (FPGA), neural network processing unit (NPU), data processor unit (DPU), accelerator (e.g., graphics accelerator, digital signal processor (DSP), compression accelerator, artificial intelligence (AI) accelerator), controller, or other types of processing units. As such, the processor unit can be referred to as an XPU (or xPU). Further, a processor unit can comprise one or more of these distinct types of processing units. In some embodiments, the computing system comprises one processor unit with multiple cores, and in other embodiments, the computing system comprises a single processor unit with a single core. As used herein, the terms "processor unit" and "processing unit" can refer to any processor, processor core, component, module, engine, circuitry, or any other processing element described or referenced herein.

In some embodiments, the computing system 700 can comprise one or more processor units that are heterogeneous or asymmetric to another processor unit in the computing system. There can be a variety of differences between the processing units in a system in terms of a spectrum of metrics of merit including architectural, microarchitectural, thermal, power consumption characteristics, and the like. These differences can effectively manifest themselves as asymmetry and heterogeneity among the processor units in a system.

The processor units 702 and 704 can be located in a single integrated circuit component (such as a multi-chip package (MCP) or multi-chip module (MCM)) or they can be located in separate integrated circuit components. An integrated circuit component comprising one or more processor units can comprise additional components, such as embedded DRAM, stacked high bandwidth memory (HBM), shared cache memories (e.g., L3, L4, LLC), input/output (I/O) controllers, or memory controllers. Any of the additional components can be located on the same integrated circuit die as a processor unit, or on one or more integrated circuit dies separate from the integrated circuit dies comprising the processor units. In some embodiments, these separate integrated circuit dies can be referred to as "chiplets". In some embodiments where there is heterogeneity or asymmetry among processor units in a computing system, the heterogeneity or asymmetric can be among processor units located in the same integrated circuit component. In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Processor units 702 and 704 further comprise memory controller logic (MC) 720 and 722. As shown in FIG. 7, MCs 720 and 622 control memories 716 and 718 coupled to the processor units 702 and 704, respectively. The memories 716 and 718 can comprise various types of volatile memory (e.g., dynamic random-access memory (DRAM), static random-access memory (SRAM)) and/or nonvolatile memory (e.g., flash memory, chalcogenide-based phase-change non-volatile memories), and comprise one or more layers of the memory hierarchy of the computing system. While MCs 720 and 722 are illustrated as being integrated into the processor units 702 and 704, in alternative embodiments, the MCs can be external to a processor unit.

Processor units 702 and 704 are coupled to an Input/Output (I/O) subsystem 730 via point-to-point interconnections 732 and 734. The point-to-point interconnection 732 connects a point-to-point interface 736 of the processor unit 702 with a point-to-point interface 738 of the I/O subsystem 730, and the point-to-point interconnection 734 connects a point-to-point interface 740 of the processor unit 704 with a point-to-point interface 742 of the I/O subsystem 730. Input/Output subsystem 730 further includes an interface 750 to couple the I/O subsystem 730 to a graphics engine 752. The I/O subsystem 730 and the graphics engine 752 are coupled via a bus 754.

The Input/Output subsystem 730 is further coupled to a first bus 760 via an interface 762. The first bus 760 can be a Peripheral Component Interconnect Express (PCle) bus or any other type of bus. Various I/O devices 764 can be coupled to the first bus 760. A bus bridge 770 can couple the first bus 760 to a second bus 780. In some embodiments, the second bus 780 can be a low pin count (LPC) bus. Various devices can be coupled to the second bus 780 including, for example, a keyboard/mouse 782, audio I/O devices 788, and a storage device 790, such as a hard disk drive, solid-state drive, or another storage device for storing computer-executable instructions (code) 792 or data. The code 792 can comprise computer-executable instructions for performing methods described herein. Additional components that can be coupled to the second bus 780 include communication device(s) 784, which can provide for communication between the computing system 700 and one or more wired or wireless networks 786 (e.g. Wi-Fi, cellular, or satellite networks) via one or more wired or wireless communication links (e.g., wire, cable, Ethernet connection, radio-frequency (RF) channel, infrared channel, Wi-Fi channel) using one or more communication standards (e.g., IEEE 802.11 standard and its supplements).

In embodiments where the communication devices 784 support wireless communication, the communication devices 784 can comprise wireless communication components coupled to one or more antennas to support communication between the computing system 700 and external devices. The wireless communication components can support various wireless communication protocols and technologies such as Near Field Communication (NFC), IEEE 802.11 (Wi-Fi) variants, WiMax, Bluetooth, Zigbee, 4G Long Term Evolution (LTE), Code Division Multiplexing Access (CDMA), Universal Mobile Telecommunication System (UMTS) and Global System for Mobile Telecommunication (GSM), and 5G broadband cellular technologies. In addition, the wireless modems can support communication with one or more cellular networks for data and voice communications within a single cellular network, between cellular networks, or between the computing system and a public switched telephone network (PSTN).

The system 700 can comprise removable memory such as flash memory cards (e.g., SD (Secure Digital) cards), memory sticks, Subscriber Identity Module (SIM) cards). The memory in system 700 (including caches 712 and 714, memories 716 and 718, and storage device 790) can store data and/or computer-executable instructions for executing an operating system 794 and application programs 796. Example data includes web pages, text messages, images, sound files, and video data biometric thresholds for particular users or other data sets to be sent to and/or received from one or more network servers or other devices by the system 700 via the one or more wired or wireless networks 786, or for use by the system 700. The system 700 can also have access to external memory or storage (not shown) such as external hard drives or cloud-based storage.

The operating system 794 (also simplified to "OS" herein) can control the allocation and usage of the components illustrated in FIG. 6 and support the one or more application programs 696. The application programs 796 can include common computing system applications (e.g., email applications, calendars, contact managers, web browsers, messaging applications) as well as other computing applications.

The computing system 700 can support various additional input devices, represented generally as user interfaces 798, such as a touchscreen, microphone, monoscopic camera, stereoscopic camera, trackball, touchpad, trackpad, proximity sensor, light sensor, electrocardiogram (ECG) sensor, PPG (photoplethysmogram) sensor, galvanic skin response sensor, and one or more output devices, such as one or more speakers or displays. Other possible input and output devices include piezoelectric and other haptic I/O devices. Any of the input or output devices can be internal to, external to, or removably attachable with the system 700. External input and output devices can communicate with the system 700 via wired or wireless connections.

In addition, one or more of the user interfaces 798 may be natural user interfaces (NUIs). For example, the operating system 794 or applications 796 can comprise speech recognition logic as part of a voice user interface that allows a user to operate the system 700 via voice commands. Further, the computing system 700 can comprise input devices and logic that allows a user to interact with computing the system 700 via body, hand or face gestures. For example, a user's hand gestures can be detected and interpreted to provide input to a gaming application.

The I/O devices 764 can include at least one input/output port comprising physical connectors (e.g., USB, IEEE 1394 (FireWire), Ethernet, RS-232), a power supply (e.g., battery), a global satellite navigation system (GNSS) receiver (e.g., GPS receiver); a gyroscope; an accelerometer; and/or a compass. A GNSS receiver can be coupled to a GNSS antenna. The computing system 700 can further comprise one or more additional antennas coupled to one or more additional receivers, transmitters, and/or transceivers to enable additional functions.

In addition to those already discussed, integrated circuit components, integrated circuit constituent components, and other components in the computing system 794 can communicate with interconnect technologies such as Intel^{®} QuickPath Interconnect (QPI), Intel^{®} Ultra Path Interconnect (UPI), Computer Express Link (CXL), cache coherent interconnect for accelerators (CCIX^{®}), serializer/deserializer (SERDES), Nvidia^{®} NVLink, ARM Infinity Link, Gen-Z, or Open Coherent Accelerator Processor Interface (OpenCAPI). Other interconnect technologies may be used and a computing system 694 may utilize more or more interconnect technologies.

It is to be understood that FIG. 7 illustrates only one example computing system architecture. Computing systems based on alternative architectures can be used to implement technologies described herein. For example, instead of the processors 702 and 704 and the graphics engine 752 being located on discrete integrated circuits, a computing system can comprise an SoC (system-on-a-chip) integrated circuit incorporating multiple processors, a graphics engine, and additional components. Further, a computing system can connect its constituent component via bus or point-to-point configurations different from that shown in FIG. 7. Moreover, the illustrated components in FIG. 7 are not required or all-inclusive, as shown components can be removed and other components added in alternative embodiments.

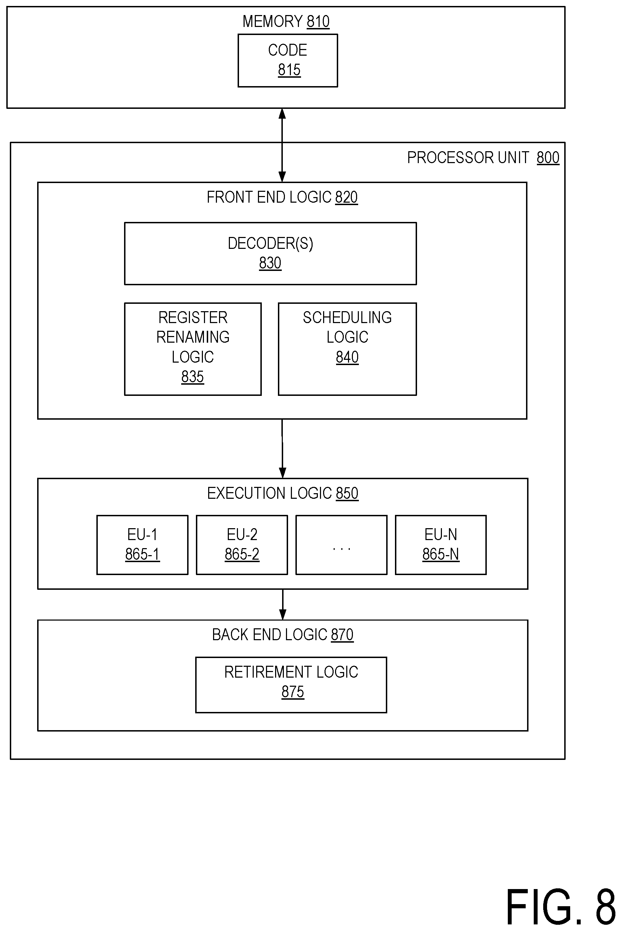

FIG. 8 is a block diagram of an example processor unit 800 to execute computer-executable instructions as part of implementing technologies described herein. The processor unit 800 can be a single-threaded core or a multithreaded core in that it may include more than one hardware thread context (or "logical processor") per processor unit.

FIG. 8 also illustrates a memory 810 coupled to the processor unit 800. The memory 810 can be any memory described herein or any other memory known to those of skill in the art. The memory 810 can store computer-executable instructions 815 (code) executable by the processor unit 800.

The processor unit comprises front-end logic 820 that receives instructions from the memory 810. An instruction can be processed by one or more decoders 830. The decoder 830 can generate as its output a micro-operation such as a fixed width micro-operation in a predefined format, or generate other instructions, microinstructions, or control signals, which reflect the original code instruction. The front-end logic 820 further comprises register renaming logic 835 and scheduling logic 840, which generally allocate resources and queues operations corresponding to converting an instruction for execution.

The processor unit 800 further comprises execution logic 850, which comprises one or more execution units (EUs) 865-1 through 865-N. Some processor unit embodiments can include a few execution units dedicated to specific functions or sets of functions. Other embodiments can include only one execution unit or one execution unit that can perform a particular function. The execution logic 850 performs the operations specified by code instructions. After completion of execution of the operations specified by the code instructions, back-end logic 870 retires instructions using retirement logic 875. In some embodiments, the processor unit 800 allows out of order execution but requires in-order retirement of instructions. Retirement logic 875 can take a variety of forms as known to those of skill in the art (e.g., re-order buffers or the like).

The processor unit 800 is transformed during execution of instructions, at least in terms of the output generated by the decoder 830, hardware registers and tables utilized by the register renaming logic 835, and any registers (not shown) modified by the execution logic 850. While at least one embodiment has been presented in the foregoing detailed description, it should be appreciated that a vast number of variations exist. It should also be appreciated that the disclosed embodiments are only examples, and are not intended to limit the scope, applicability, or configuration of the disclosure in any way. Rather, the foregoing detailed description will provide those skilled in the art with a convenient road map for implementing the disclosed aspects of the present disclosure. Various changes can be made in the function and arrangement of elements without departing from the scope of the disclosure as set forth in the appended claims and the legal equivalents thereof.

Any of the disclosed methods (or a portion thereof) can be implemented as computer-executable instructions or a computer program product. Such instructions can cause a computing system or one or more processor units capable of executing computer-executable instructions to perform any of the disclosed methods. As used herein, the term "computer" refers to any computing system, device, or machine described or mentioned herein as well as any other computing system, device, or machine capable of executing instructions. Thus, the term "computer-executable instruction" refers to instructions that can be executed by any computing system, device, or machine described or mentioned herein as well as any other computing system, device, or machine capable of executing instructions.

The computer-executable instructions or computer program products as well as any data created and/or used during implementation of the disclosed technologies can be stored on one or more tangible or non-transitory computer-readable storage media, such as volatile memory (e.g., DRAM, SRAM), non-volatile memory (e.g., flash memory, chalcogenide-based phase-change nonvolatile memory) optical media discs (e.g., DVDs, CDs), and magnetic storage (e.g., magnetic tape storage, hard disk drives). Computer-readable storage media can be contained in computer-readable storage devices such as solid-state drives, USB flash drives, and memory modules. Alternatively, any of the methods disclosed herein (or a portion) thereof may be performed by hardware components comprising non-programmable circuitry. In some embodiments, any of the methods herein can be performed by a combination of non-programmable hardware components and one or more processing units executing computer-executable instructions stored on computer-readable storage media.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any computer system or type of hardware.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

Additionally, theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

As used herein, phrases such as "embodiments," "an aspect of the present disclosure," "various aspects of the present disclosure," "some aspects of the present disclosure," and the like, indicate that some aspects of the present disclosure may have some, all, or none of the features described for other aspects of the present disclosure. "First," "second," "third," and the like describe a common object and indicate different instances of like objects being referred to; unless specifically stated, they do not imply a given sequence, either temporally or spatially, in ranking, or any other manner. In accordance with patent application parlance, "connected" indicates elements that are in direct physical or electrical contact with each other and "coupled" indicates elements that co-operate or interact with each other, coupled elements may or may not be in direct physical or electrical contact. Furthermore, the terms "comprising," "including," "having," and the like, are utilized synonymously to denote non-exclusive inclusions.

As used in this application and the claims, a list of items joined by the term "at least one of" can mean any combination of the listed terms. For example, the phrase "at least one of A, B and C" can mean A; B; C; A and B; A and C; B and C; or A, B, and C. Similarly, as used in this application and the claims, a list of items joined by the term "one or more of" can mean any combination of the listed terms. For example, the phrase "one or more of A, B and C" can mean A; B; C; A and B; A and C; B and C; or A, B, and C.

The following Examples pertain to additional aspects of the present disclosure of technologies disclosed herein.
1. Example 1 is a method comprising: accessing three layers of optical proximity correction (OPC) data, wherein the three layers are three of a plurality of layers of OPC data generated for a drawn integrated circuit layout characterized for a foundry process node; wherein the three layers comprise a first metal layer, a second metal layer, and a via layer; wherein a feature is formed in the three layers; receiving a first user input defining a check for the feature, wherein the check includes a geometric analysis and a limit; receiving a second user input defining the limit; performing the check on the feature; and generating a flag for the feature when the limit is exceeded.
2. Example 2 includes the subject matter of Example 1, wherein the feature is a via, and the limit is a minimum area for the via.
3. Example 3 includes the subject matter of Example 1, wherein the feature is a via-to-metal short, and the limit is a distance between a via and a metal trace.
4. Example 4 includes the subject matter of any one of Examples 1-3, wherein the feature is one of a plurality of features formed in the three layers, and further comprising: performing the check on the plurality of features; and generating a respective flag when the limit is exceeded for a feature of the plurality of features.
5. Example 5 includes the subject matter of Example 1, wherein the feature is one of a plurality of features formed in the three layers, the plurality of features is a plurality of vias, and the check is to predict, for the plurality of vias, a distance shift by individual vias from respective metal traces and further comprising: performing the check on the plurality of features; and generating a respective flag when the limit is exceeded for a feature of the plurality of features.
6. Example 6 includes the subject matter of Example 4 or Example 5, further comprising predicting a potential yield issue related to the feature based on an occurrence of flags.
7. Example 7 includes the subject matter of Example 4 or Example 5, further comprising predicting a potential yield issue related to the feature based on a location of flags.
8. Example 8 includes the subject matter of any one of Examples 1-7, wherein the feature is a first feature, the check is a first check, the limit is a first limit, the flag is a first flag, and a second feature is formed in the three layers, and further comprising: receiving a third user input defining a second check for the second feature, wherein the second check includes a second geometric analysis and a second limit; receiving a fourth user input defining the second limit; performing the second check on the second feature; and generating a second flag for the second feature when the second limit is exceeded.
9. Example 9 is a system, comprising: an optical proximity correction (OPC) module to generate a plurality of layers of OPC contour data for a drawn integrated circuit layout characterized for a foundry process node; and a multi-layer OPC metrology module to: access three layers of the plurality of layers of the OPC contour data, wherein the three layers comprise a first metal layer, a second metal layer, and a via layer, wherein a feature is formed in the three layers; receive a first user input defining a check for the feature, wherein the check includes a geometric analysis and a limit; receive a second user input defining the limit; perform the check on the feature; and generate a flag for the feature when the limit is exceeded.
10. Example 10 includes the subject matter of Example 9, wherein the feature is one of a plurality of features formed in the three layers, and the multi-layer OPC metrology module is further to: perform the check on the plurality of features; and generate a respective flag for a feature of the plurality of features when the limit is exceeded for the feature.
11. Example 11 includes the subject matter of Example 10, wherein the plurality of features is a plurality of vias, and the check is to predict, for the plurality of vias, a distance shift by individual vias from respective metal traces.
12. Example 12 includes the subject matter of Example 10 or Example 11, wherein the multi-layer OPC metrology module is further to predict a potential yield issue related to the feature based on an occurrence of flags.
13. Example 13 includes the subject matter of Example 10 or Example 11, wherein the multi-layer OPC metrology module is further to predict a potential yield issue related to the feature based on a location of flags.
14. Example14 includes the subject matter of any one of Examples 9-13, wherein the feature is a first feature, the check is a first check, the limit is a first limit, the flag is a first flag, and a second feature is formed in the three layers, and the multi-layer OPC metrology module is further to: receive a third user input defining a second check for the second feature, wherein the second check includes a second geometric analysis and a second limit; receive a fourth user input defining the second limit; perform the second check on the second feature; and generate a second flag for the second feature when the second limit is exceeded.
15. Example 15 includes the subject matter of Example 14, wherein the first check is a via coverage check, the first limit is a minimum area, the second check is a via-to-metal short, and the second limit is a minimum distance.
16. Example 16 includes the subject matter of Example 14, wherein the three layers comprise a plurality of first features and a plurality of second features, and the OPC metrology module is further to: perform the first check on the plurality of first features; perform the second check on the plurality of second features; generate a respective first flag when the first limit is exceeded for a first feature of the plurality of first features; and generate a respective second flag when the second limit is exceeded for a second feature of the plurality of first features.
17. Example 17 is one or more computer-readable storage media storing computer-executable instructions which when executed by a processor cause the processor to perform a method, the method comprising: accessing three layers of optical proximity contour (OPC) data, wherein the three layers are three of a plurality of layers of OPC data generated for a drawn integrated circuit layout characterized for a foundry process node; wherein the three layers comprise a first metal layer, a second metal layer, and a via layer; wherein a feature is formed in the three layers; receiving a first user input defining a check for the feature, wherein the check includes a geometric analysis and a limit; receiving a second user input defining the limit; performing the check on the feature; and generating a flag for the feature when the limit is exceeded.
18. Example 18 includes the subject matter of Example 17, wherein the feature is a via, and the limit is a minimum area for the via.
19. Example 19 includes the subject matter of Example 17, wherein the feature is a via-to-metal short, and the limit is a distance between a via and a metal trace.
20. Example 20 includes the subject matter of Example 17, wherein the feature is one of a plurality of features formed in the three layers, and wherein the method further comprises: performing the check on the plurality of features; and generating a respective flag when the limit is exceeded for a feature of the plurality of features.

## Claims

1. A method comprising:
accessing three layers of optical proximity correction (OPC) data, wherein the three layers are three of a plurality of layers of OPC data generated for a drawn integrated circuit layout characterized for a foundry process node;
wherein the three layers comprise a first metal layer, a second metal layer, and a via layer;
wherein a feature is formed in the three layers;
performing a check on the feature, wherein the check includes a geometric analysis and a limit; and
generating a flag for the feature when the limit is exceeded.

2. The method of claim 1, wherein the feature is a via of the via layer, and the limit is a minimum coverage area of the via by a first metal trace of the first metal layer and a second metal trace of the second metal layer.

3. The method of claim 1, wherein the feature is a via-to-metal distance, and the limit is a minimum distance between a via of the via layer and a metal trace of the first metal layer or the second metal layer.

4. The method of any one of claims 1-3, wherein the feature is one of a plurality of features formed in the three layers, and further comprising:
performing the check on the plurality of features; and
generating a respective flag when the limit is exceeded for a feature of the plurality of features.

5. The method of claim 4, wherein the plurality of features is a plurality of vias, and the check is to predict, for the plurality of vias, a distance shift by individual vias from respective metal traces.

6. The method of claim 4 or 5, further comprising predicting a potential yield issue related to the feature based on an occurrence of flags.

7. The method of claim 4 or 5, further comprising predicting a potential yield issue related to the feature based on a location of flags.

8. The method of any one of claims 1-7, wherein the feature is a first feature, the check is a first check, the limit is a first limit, the flag is a first flag, and a second feature is formed in the three layers, and further comprising:
receiving a third user input defining a second check for the second feature, wherein the second check includes a second geometric analysis and a second limit;
receiving a fourth user input defining the second limit;
performing the second check on the second feature; and
generating a second flag for the second feature when the second limit is exceeded.

9. The method of claim 1 or 2, wherein the limit is based on electrical test data from skews designed to evaluate via opens.

10. The method of claim 1 or 3, wherein the limit is based on electrical test data from skews designed to evaluate via-to-metal opens.

11. The method of any one of claims 1-10, further comprising:
receiving a first user input defining the check for the feature; and
receiving a second user input defining the limit.

12. The method of any one of claims 1-11, wherein the feature comprises a metal trace of the first metal layer, wherein the metal trace was shifted during OPC.

13. A system comprising:
one or more processing units; and
one or more computer-readable media storing instructions that, when executed by the one or more processing units, cause the system to perform the method of any one of claims 1-12.

14. One or more computer-readable media storing instructions that, when executed by one or more processing units, cause the one or more processing units to perform that method of any one of claims 1-12.

15. A system comprising means to perform the method of any one of claims 1-12.
